# EUROPÄISCHE PATENTSCHRIFT

(11) **EP 1 352 467 B1**
(45) Veröffentlichungstag und Bekanntmachung des Hinweises auf die Patenterteilung: **29.09.2004**
(21) Anmeldenummer: 01985849.7
(22) Anmeldetag: 05.12.2001
(51) Int. Cl.: H03F 3/45

(54) **SCHALTUNGSANORDNUNG ZUR RAUSCHARMEN VOLLDIFFERENZIELLEN VERSTÄRKUNG**
LOW NOISE FULLY DIFFERENTIAL AMPLIFIER
CIRCUIT PERMETTANT UNE AMPLIFICATION ENTIEREMENT DIFFERENTIELLE A FAIBLE BRUIT

(30) Priorität: 22.12.2000 DE 10064207
(43) Veröffentlichungstag der Anmeldung: 15.10.2003
(73) Patentinhaber: Infineon Technologies AG, 81669 München (DE)
(72) Erfinder: SCHIMPER, Markus, 85452 Moosinning (DE); MECHNIG, Stephan, 81739 München (DE); SCHLEDZ, Ralf, 85406 Zolling (DE)
(74) Vertreter: Barth, Stephan Manuel, Dr.
(86) Internationale Anmeldenummer: PCT/EP2001/014288
(87) Internationale Veröffentlichungsnummer: WO 2002/052720

(56) Entgegenhaltungen:
- EP-A- 0 641 069
- US-A- 4 742 308
- US-A- 5 420 539
- US-A- 5 455 539
- CLAESSEN U ET AL: "ERHOHTE GENAUIGKEIT BEI DER SIMULATION ANALOGER CMOS-SCHALTUNGEN DURCH EIN VERBESSERTES MOS-KOMPAKTMODELL" ARCHIV FUR ELEKTRONIK UND UBERTRAGUNGSTECHNIK, S.HIRZEL VERLAG. STUTTGART, DE, Bd. 44, Nr. 2, 1. März 1990 (1990-03-01), Seiten 139-147, XP000113073 ISSN: 0001-1096
- BANU M ET AL: "FULLY DIFFERENTIAL OPERATIONAL AMPLIFIERS WITH ACCURATE OUTPUT BALANCING" IEEE JOURNAL OF SOLID-STATE CIRCUITS, IEEE INC. NEW YORK, US, Bd. 23, Nr. 6, 1. Dezember 1988 (1988-12-01), Seiten 1410-1414, XP000070966 ISSN: 0018-9200 in der Anmeldung erwähnt

## Beschreibung

Die vorliegende Erfindung betrifft eine Schaltungsanordnung zur rauscharmen volldifferenziellen Verstärkung, gemäß dem Oberbegriff des Anspruchs 1, wie aus der US-A-5, 420, 539 bekannt.

Aus *Claessen U* et al: "Erhöhte Genauigkeit bei der Simulation analoger CMOS-Schaltungen durch ein verbessertes MOS-Kompaktmodell" Archiv für Elektronik und Übertragungstechnik, S. Hirzel Verlag. Stuttgart, DE, Bd 44 Nr. 2, 1. März 1990 (1990-03-01) Seiten 139-147, XP000113073 ISSN: 0001-1096, ist es bekannt, einen Bias-Strom mehrmals zu spiegeln, um mehrere Elemente eines Verstärkers mit dem Bias-Strom zu versorgen.

Volldifferenzielle Verstärker werden in vielen Bereichen eingesetzt, wo es darum geht, Differenzsignale über einen breiten Betriebsfrequenzbereich zu verstärken. Insbesondere - aber nicht ausschließlich - werden diese volldifferenziellen Verstärker zur Verstärkung extrem kleiner Eingangssignale in möglichst rauschfreie Ausgangssignale eingesetzt. In volldifferenziellen Verstärkern ist im allgemeinen eine Gleichtaktregelung zur Einstellung einer Gleichtaktspannung am Verstärkerausgang erforderlich. Diese Gleichtaktregelung muß eine oder beide der folgenden Forderungen erfüllen:
(a) eine ausreichende Verstärkungsbandbreite der Gesamtschaltungsanordnung muß gewährleistet sein; und
(b) ein Rauschen der Gesamtschaltungsanordnung darf vorgegebene Grenzen nicht überschreiten.

Hierbei ist zu bemerken, daß die unter (b) angegebene Randbedingung insbesondere das 1/f-Rauschen umfaßt. Die beiden o.a. Forderungen ((a)(b)) widersprechen sich, da ein geringes 1/f-Rauschen an die Schaltungselemente zur Verstärkung der Signale beträchtliche Anforderungen stellt. D.h., im allgemeinen sind Feldeffekttransistoren mit sehr großer Gate-Fläche erforderlich, die wiederum die Bandbreite der Gleichtaktregelschleife begrenzen. Werden hingegen Transistoren mit kleiner Gate-Fläche eingesetzt, dann wird das 1/f-Rauschen des Verstärkers erhöht.

Wird die Verstärkungsbandbreite zu klein, treten Effekte wie Nichtlinearitäten im Verstärkerverhalten und eine Verzerrung von Eingangssignalen in besonderem Maße auf.

Nach dem Stand der Technik werden analoge Schaltungsanordnungen zur differenziellen Verstärkung von Eingangssignalen angegeben. Aus "Analog Integrated Circuit Design" von David Johns, Ken Martin, Seiten 290-291 ist eine Schaltungsanordnung bekannt, die eine Gleichtaktregelung umfaßt, wobei die Gleichtaktspannung am Verstärkerausgang, abzüglich eines Gleichspannungspegels für eine Verschiebung, bei einem Rückführknoten V_{A} erzeugt wird.

Diese Spannung wird dann mit einer Referenzspannung V_{ref} unter Verwendung eines zusätzlichen Verstärkers verglichen. Obwohl dieser Zugang funktioniert, weist er erhebliche Einschränkungen auf. Diese Einschränkungen bestehen darin, daß der Spannungsabfall über Source-Folgetransistoren die differenziellen Signale'begrenzt, die verarbeitet werden können. Diese Begrenzung wirkt sich insbesondere dann nachteilig aus, wenn geringe Versorgungsspannungen verwendet werden. Zusätzlich führen die weiteren Knoten im Gleichtaktregelkreis dazu, daß die gesamte Schaltungsanordnung schwieriger zum kompensieren ist.

Eine wichtige Überlegung bei der Auslegung von Gleichtaktregelschaltungen besteht darin, daß sie zu kompensieren sind. Andernfalls kann die Schaltungen instabil werden.

Eine weitere Schaltungsanordnung zur volldifferenziellen Verstärkung mittels Operationsverstärkern mit einer genauen Ausgangsbalancierung gemäß dem Oberbegriff des Anspruchs 1 ist aus dem IEEE-Journal of Solid State Circuits (1988) Band 23, Nr. 6, Seiten 1410-1414 bekannt. Ein Operationsverstärker mit balanciertem Ausgang ist ein Spezialfall des bekannten Verstärkers mit differenziellem Ausgang. Verstärker mit differenziellem Ausgang enthalten üblicherweise die erwähnte Gleichtaktregelschaltung. Hierbei sind jedoch die Ausgänge bestimmter Schaltungsauslegungen nicht balanciert.

Eine weitere Schaltungsanordnung zur Gleichtaktregelung ist für Strommodus-Anwendungen hoher Impedanz aus den IEEE Transactions on Circuits and Systems II: "Analog and Digital Processing (2000)" Band 47, Nr. 4, Seiten 363-369 unter dem Titel "A continuous-time common-mode feedback circuit (CMFB) for high-impedance current-mode applications" von Lah, L.; Choma, J., Jr. und Draper, J. bekannt. Hierbei stabilisiert eine Gleichtaktregelung das Gleichtaktsignal.

Ein Hauptnachteil der Schaltungsanordnungen nach dem Stand der Technik besteht darin, daß Stabilitätsprobleme infolge der Einführung eines Pols in die Gleichtaktregelschleife auftreten. Das Auftreten eines Pols kann nach den Schaltungsanordnungen im Stand der Technik prinzipiell nicht vermieden werden. Eine Stabilisierung der Gleichtaktregelung kann bei einer Schaltungstopologie nach dem Stand der Technik nur stabilisiert werden, wenn die Verstärkungsbandbreite durch entsprechende Schaltungsmaßnahmen zu niedrigen Frequenzen hin verschoben wird, so daß ein Pol, der in herkömmlichen Schaltungsanordnungen auftritt, zu einem dominanten Pol wird.

Gewöhnlich liegt der Pol bei Schaltungsanordnungen nach dem Stand der Technik wegen großer Differenzverstärker-Transistoren bei niedrigen Frequenzen, so daß die Differenzverstärker-Schaltungsanordnung stark frequenzkompensiert werden muß, was wiederum zu einer weiteren Verringerung der Bandbreite führt. Dies hat zur Folge, daß die Verstärkung aufgrund der geringen Bandbreite mit zunehmender Frequenz abnimmt, wodurch eine Verzerrung der zu verstärkenden Eingangssignale herbeigeführt wird.

Somit besteht ein weiterer Nachteil von herkömmlichen Schaltungsanordnungen mit differenziellen Verstärkern darin, daß nur eine geringe Verstärkungsbandbreite erreicht werden kann.

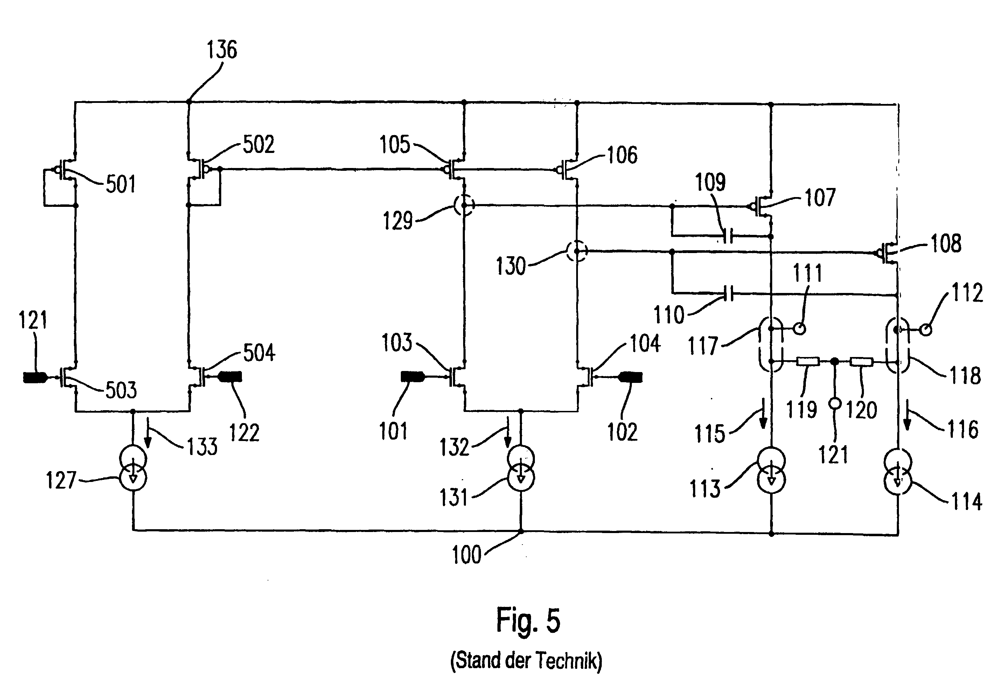

Fig. 5 zeigt eine Schaltungsanordnung zur differenziellen Verstärkung eines differenziellen Eingangssignals in ein entsprechendes differenzielles Ausgangssignal nach dem Stand der Technik.

Wie in Fig. 5 gezeigt, wird eine Gleichtaktspannung mit einem Spannungsteiler zwischen den beiden Ausgängen einer Differenzausgangsstufe der Schaltungsanordnung ermittelt. Die Gleichtaktreferenzspannung wird in einer Referenzstufe, die mit zwei Referenztransistoren und mit zwei Referenzlasten ausgebildet ist, mit einer Referenzspannung verglichen. Hierbei sind die Referenztransistoren als ein erster Referenzdifferenztransistor und ein zweiter Referenzdifferenztransistor ausgebildet.

Diese Gleichtaktregelung kann in differenziellen Verstärkern, die durch ein 1/f-Rauschen begrenzt sind, nur dann eingesetzt werden, wenn die Gleichtaktregelung entweder eine geringe Gleichspannungsverstärkung aufweist oder sehr langsam ist. Die Transistoren, die zu dieser Gleichtaktregelung eingesetzt werden, sind großflächig, was bedeutet, daß sie eine große Gate-Fläche aufweisen, wodurch das 1/f-Rauschen verringert wird. Der damit gebildete Stromspiegel führt dazu, daß ein zusätzlicher Pol in die Gleichtaktregelschleife eingeführt wird, der zu dem schaltungstechnischen Nachteil führt, daß Stabilitätsprobleme in der Gleichtaktregelung auftreten.

Somit ist es eine Hauptaufgabe der vorliegenden Erfindung, eine Gleichtaktregelung für einen differenziellen Verstärker bereitzustellen, wobei der differenzielle Verstärker eine große Verstärkungsbandbreite aufweisen soll.

Es ist eine weitere Aufgabe der vorliegenden Erfindung, das 1/f-Rauschen zu begrenzen.

Noch eine weitere Aufgabe der vorliegenden Erfindung ist es, eine Verzerrung von Eingangssignalen, die durch eine zu geringe Verstärkungsbandbreite hervorgerufen wird, zu verhindern.

Die erfindungsgemäße Vorrichtung weist den Hauptvorteil auf, daß eine Gleichtaktregelung für einen rauscharmen, volldifferenziellen Verstärker bereitgestellt wird, wobei eine große Bandbreite aufrecht erhalten wird, ohne das 1/f-Rauschen zu erhöhen.

Ein weiterer Vorteil der vorliegenden Erfindung besteht in der Bereitstellung einer Gleichtaktregelung, die keinen zusätzlichen Pol erzeugt.

Noch ein weiterer Vorteil der vorliegenden Erfindung besteht in der Bereitstellung einer Gleichtaktregelung, bei der nur ein Teilstrom geregelt wird.

Noch ein weiterer Vorteil der vorliegenden Erfindung besteht in der Bereitstellung einer Start-Schaltungseinheit, die ein Starten und ein Einstellen eines geeigneten Arbeitspunkts ermöglicht.

Kern der Erfindung ist eine Schaltungsanordnung zur volldifferenziellen Verstärkung mir geringem 1/f-Rauschen und einer Gleichtaktregelung, bei der nur ein Teilstrom geregelt wird.

Gemäß einer bevorzugten Weiterbildung der vorliegenden Erfindung ist ein Anpasstransistor bereitgestellt, der gewährleistet, daß eine Anpassung zwischen den eingesetzten Stromquellen erreicht wird.

Gemäß einer weiteren bevorzugten Weiterbildung der vorliegenden Erfindung ist eine Start-Schaltungseinheit, bestehend aus einem ersten Starttransistor und einem zweiten Starttransistor, bereitgestellt, um ein Starten der Gesamtschaltungsanordnung zu ermöglichen.

Gemäß noch einer weiteren bevorzugten Weiterbildung der vorliegenden Erfindung wird für eine Gleichtaktregelung eine Gleichtaktspannung als ein Rückführsignal über einen Spannungsteiler ermittelt, der zwischen einem ersten Ausgangsschaltungsknoten, der mit einem ersten Ausgangssignal beaufschlagt ist, und einem zweiten Ausgangsschaltungsknoten, der mit einem zweiten Ausgangssignal beaufschlagt ist, angeordnet ist.

Gemäß noch einer weiteren bevorzugten Weiterbildung der vorliegenden Erfindung wird eine Gleichtaktspannung an der Ausgangsstufe zwischen Drain-Anschlüssen der ersten und zweiten Ausgangstransistoren abgreifbar.

Gemäß noch einer weiteren bevorzugten Weiterbildung der vorliegenden Erfindung ist eine Gleichtaktregelung bereitgestellt, bei welcher ein Referenzstrom zur Regelung benutzt wird, der nur ein Teil des durch eine Laststromquelle bereitgestellten Laststroms ist.

Gemäß noch einer weiteren bevorzugten Weiterbildung der vorliegenden Erfindung sind in der Differenzeingangsstufe erste und zweite Starttransistoren bereitgestellt, die jeweils parallel zu den ersten und zweiten Eingangstransistoren geschaltet sind.

Gemäß noch einer weiteren bevorzugten Weiterbildung der vorliegenden Erfindung sind zweite und dritte Referenztransistoren bereitgestellt, die eine Steilheit kleiner als jene der ersten und zweiten Eingangstransistoren aufweisen.

Gemäß der vorliegenden Erfindung ist eine Gleichtaktregelung bereitgestellt, die einen zusätzlichen Pol vermeidet.

Gemäß noch einer weiteren bevorzugten Weiterbildung der vorliegenden Erfindung ist ein Anpasstransistor bereitgestellt, dessen Gate-Anschluss mit einer Referenzspannung beaufschlagt ist, und dessen Drain-Source-Strecke den Laststrom durchleitet.

Gemäß noch einer weiteren bevorzugten Weiterbildung der vorliegenden Erfindung ist eine erste Referenzlast eines ersten Referenztransistors durch einen Widerstand ausgebildet.

Gemäß noch einer weiteren bevorzugten Weiterbildung der vorliegenden Erfindung ist eine erste Referenzlast eines ersten Referenztransistors durch eine Diodenlast ausgebildet.

Gemäß noch einer weiteren bevorzugten Weiterbildung der vorliegenden Erfindung ist eine Last des Anpasstransistors als ein als eine Diodenlast geschalteter Lasttransistor ausgebildet.

Ausführungsbeispiele der Erfindung sind in den Zeichnungen dargestellt und in der nachfolgenden Beschreibung näher erläutert.

Es zeigen:
- Fig. 1: eine Schaltungsanordnung zur Verstärkung eines aus einem ersten Eingangssignal 101 und einem zweiten Eingangssignal 102 zusammengesetzten Gesamteingangssignals zur Bildung eines einem ersten Ausgangssignal 111 und einem zweiten Ausgangssignal 112 zusammengesetzten Ausgangssignals gemäß der vorliegenden Erfindung;
- Fig. 2: ein Ausführungsbeispiel einer Schaltungsanordnung gemäß der vorliegenden Erfindung, wobei die in Fig. 1 gezeigte Schaltungsanordnung um eine aus einem ersten Starttransistor 201 und einem zweiten Starttransistor 202 bestehende Start-Schaltungseinheit erweitert ist;
- Fig. 3: ein Ausführungsbeispiel einer Schaltungsanordnung gemäß der vorliegenden Erfindung, wobei die in Fig. 3 gezeigte Schaltungsanordnung der in Fig. 2 gezeigten Schaltungsanordnung bis auf eine Bereitstellung eines zusätzlichen Anpasstransistors 301 entspricht;
- Fig. 4: ein Ausführungsbeispiel einer Schaltungsanordnung gemäß der vorliegenden Erfindung, wobei die in Fig. 4 gezeigte Schaltungsanordnung der in Fig. 3 gezeigten Schaltungsanordnung bis auf eine Bereitstellung einer zusätzlichen ersten Referenzlast 401 in einer Referenzstufe der Fig. 3 entspricht;
- Fig. 5: eine Schaltungsanordnung zur differenziellen Verstärkung eines differenziellen Eingangssignals in ein entsprechendes differenzielles Ausgangssignal nach dem Stand der Technik.

In den Figuren bezeichnen gleiche Bezugszeichen gleiche oder funktionsgleiche Komponenten.

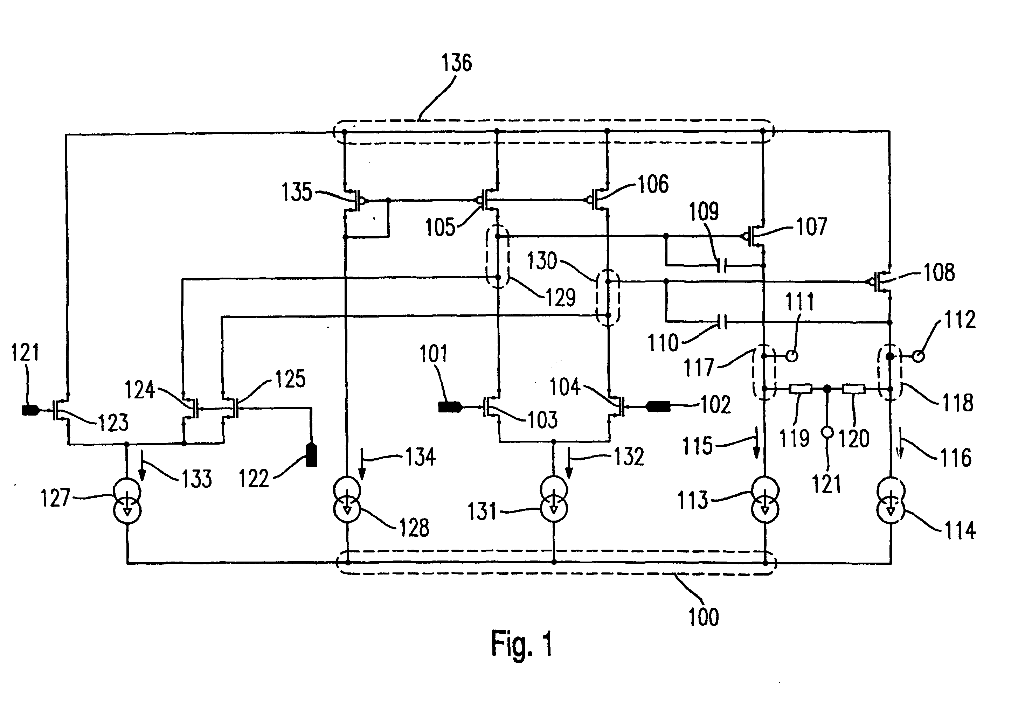

Fig. 1 zeigt eine Schaltungsanordnung zur Verstärkung eines aus einem ersten Eingangssignal 101 und einem zweiten Eingangssignal 102 zusammengesetzten Gesamteingangssignals zur Bildung eines aus einem ersten Ausgangssignal 111 und einem zweiten Ausgangssignal 112 zusammengesetzten Ausgangssignals gemäß der vorliegenden Erfindung.

Bei der in Fig. 1 gezeigten Schaltungsanordnung wird ein erstes Eingangssignal 101 einem Gate-Anschluss eines ersten Eingangstransistors 103 zugeführt, während ein zweites Eingangssignal 102 einem Gate-Anschluss eines zweiten Eingangstransistors 104 zugeführt wird. Die Source-Anschlüsse der beiden Transistoren 103 und 104 sind untereinander verbunden und mit einem ersten-Anschluß einer Eingangsstromquelle 131 verbunden, deren zweiter Anschluß mit einem Masseschaltungsknoten 100 verbunden ist, wobei die Eingangsstromquelle 131 einen Eingangsstrom 132 treibt.

Der Drain-Anschluss des ersten Transistors 103 ist mit einem ersten Referenzschaltungsknoten 129 verbunden, während der Drain-Anschluss des zweiten Transistors 104 mit einem zweiten Referenzschaltungsknoten 130 verbunden ist. Weiterhin ist der Gate-Anschluss eines ersten Ausgangstransistors 107 mit dem ersten Referenzschaltungsknoten 129 verbunden ist, während der Gate-Anschluss eines zweiten Ausgangstransistors 108 mit dem zweiten Referenzschaltungsknoten 130 verbunden ist. Über die beiden Referenzschaltungsknoten 129 und 130 wird eine Gleichtaktregelung erreicht, indem der Drain-Anschluss eines zweiten Referenztransistors 124 mit dem ersten Referenzschaltungsknoten 129 verbunden ist, während der Drain-Anschluss eines dritten Referenztransistors mit dem zweiten Referenzschaltungsknoten 130 verbunden ist. Der Drain-Anschluss eines ersten Stromspiegeltransistors 105 ist ebenfalls mit dem ersten Referenzschaltungsknoten 129 verbunden, während der Drain-Anschluss eines zweiten Stromspiegeltransistors 106 mit dem zweiten Referenzschaltungsknoten 130 verbunden ist.

Der Gate-Anschluss des ersten Stromspiegeltransistors 105 ist mit dem Gate-Anschluss des zweiten Stromspiegeltransistors 106 und dem Gate-Anschluss eines Lasttransistors 135 verbunden, wobei die Gate- und Drain-Anschlüsse des Lasttransistors 135 untereinander verbunden sind, um so eine Diodenlast auszubilden. Weiterhin ist der Drain-Anschluss (bzw. ebenfalls der Gate-Anschluss) des Lasttransistors 135 mit einem ersten Anschluß einer Laststromquelle 128 verbunden, während ein zweiter Anschluß der Laststromquelle 128 mit dem Masseschaltungsknoten 100 verbunden ist. Auf diese Weise wird ein Laststrom 134 von der Laststromquelle 128 getrieben. Die Source-Anschlüsse des Lasttransistors 135, des ersten Stromspiegeltransistors 105, des zweiten Stromspiegeltransistors 106, des ersten Ausgangstransistors 107 und des zweiten Ausgangstransistors 108 sind mit einem Versorgungsschaltungsknoten 136 verbunden, an welchen eine Versorgungsspannung angelegt ist. Die Gate-Anschlüsse der zweiten und dritten Referenztransistoren 124 und 125 sind untereinander und mit einer Referenzspannung 122 verbunden. Die Source-Anschlüsse eines ersten Referenztransistors 123, dessen Drain-Anschluss mit dem Versorgungsschaltungsknoten 136 verbunden ist, und der zweiten und dritten Referenztransistoren 124 und 125 sind untereinander und mit einem ersten Anschluß einer Referenzstromquelle 127 verbunden, deren zweiter Anschluß mit dem Masseschaltungsknoten 100 verbunden ist, wodurch ein Referenzstrom 133 getrieben wird. Auf diese Weise wird durch die Bereitstellung einer Referenzstufe, die im wesentlichen aus den ersten, zweiten und dritten Referenztransistoren 123, 124 und 125, sowie aus der Referenzstromquelle 127 besteht, ermöglicht, daß ein Rückführsignal 121 (die Erzeugung des Rückführsignals wird untenstehend beschrieben werden) mit der Referenzspannung 122 verglichen und auf deren Wert geregelt werden kann.

Das Rückführsignal 121 wird mit Hilfe eines aus einem ersten Rückführwiderstand 119 und einem zweiten Rückführwiderstand 120 gebildeten Spannungsteilers im Ausgangskreis der differenziellen Verstärker-Schaltungsanordnung gewonnen. Hierbei ist ein erster Anschluß des ersten Rückführwiderstands 119 mit einem ersten Ausgangsschaltungsknoten 117 verbunden, während ein erster Anschluß des zweiten Rückführwiderstands 120 mit einem zweiten Ausgangsschaltungsknoten 118 verbunden ist. Der zweite Anschluß des ersten Rückführwiderstands 119 ist mit dem zweiten Anschluß des zweiten Rückführwiderstands 120 verbunden, wobei am Verbindungspunkt der beiden Rückführwiderstände ein Rückführsignal 121 abgreifbar ist.

An dem ersten Ausgangsschaltungsknoten 117 wird ein erstes Ausgangssignal 111 bereitgestellt, während an dem zweiten Ausgangsschaltungsknoten 118 ein zweites Ausgangssignal 112 bereitgestellt wird. Die jeweiligen ersten und zweiten Ausgangssignale 111 bzw. 112 bilden ein Gesamtausgangssignal, das einem aus den ersten und zweiten Eingangssignalen 101 bzw. 102 zusammengesetzten Eingangssignal entspricht. Der Drain-Anschluss des ersten Ausgangstransistors 107 ist mit dem ersten Ausgangsschaltungsknoten 117 verbunden, der wiederum mit einem ersten Anschluß einer ersten Ausgangsstromquelle 113 verbunden ist, wobei der zweite Anschluß der ersten Ausgangsstromquelle 113 mit dem Masseschaltungsknoten 100 verbunden ist. Der Drain-Anschluss des zweiten Ausgangstransistors 108 ist mit dem zweiten Ausgangsschaltungsknoten 118 verbunden, der wiederum mit einem ersten Anschluß einer zweiten Ausgangsstromquelle 114 verbunden ist, wobei ein zweiter Anschluß der Ausgangsstromquelle 114 mit dem Masseschaltungsknoten 100 verbunden ist. Auf diese Weise werden ein erster Ausgangsstrom 115 von der ersten Ausgangsstromquelle 113 und einer zweiter Ausgangsstrom 116 von der zweiten Ausgangsstromquelle 114 getrieben.

Zwischen dem Gate-Anschluss und dem Drain-Anschluss des ersten Ausgangstransistors 107 ist eine erste Kompensationskapazität 109 verbunden, während zwischen dem Gate-Anschluss und dem Drain-Anschluss des zweiten Ausgangstransistors 108 eine zweite Kompensationskapazität 110 verbunden ist.

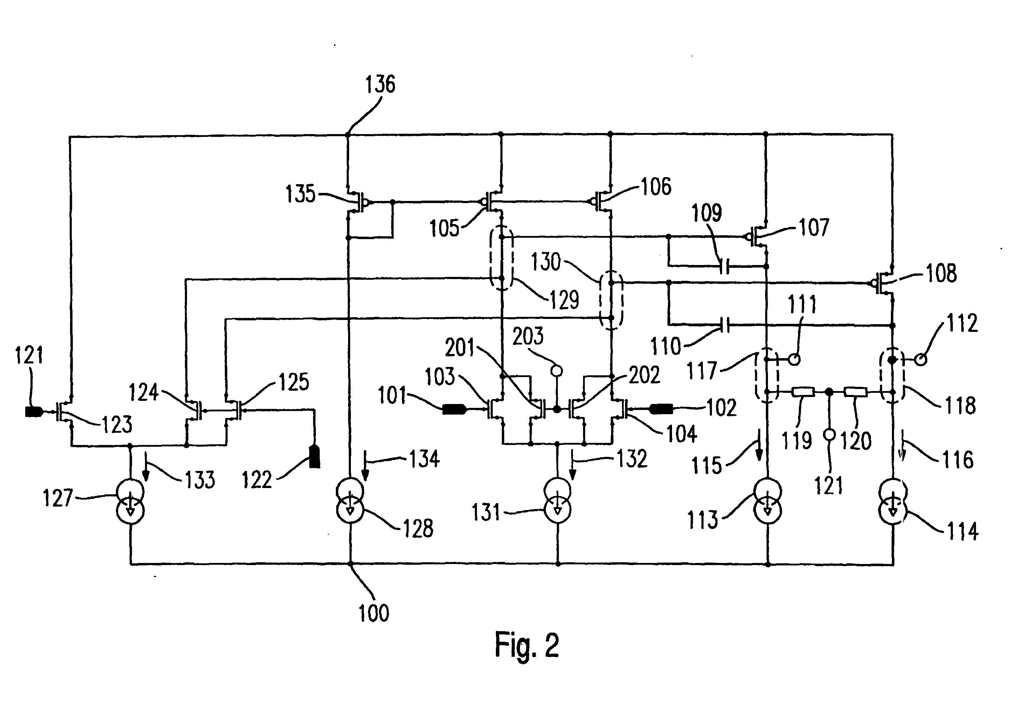

Fig. 2 veranschaulicht ein Ausführungsbeispiel einer Schaltungsanordnung gemäß der vorliegenden Erfindung, wobei die in Fig. 1 gezeigte Schaltungsanordnung um eine aus einem ersten Starttransistor 201 und einem zweiten Starttransistor 202 bestehende Start-Schaltungseinheit erweitert ist.

Bei der in Fig. 2 gezeigten Schaltungsanordnung sind zwei zusätzliche Transistoren, ein erster Starttransistor 201 und ein zweiter Starttransistor 202 dargestellt, wobei die Drain-Anschlüsse des ersten Starttransistors 201 und des ersten Eingangstransistors 103 untereinander und die Source-Anschlüsse des ersten Starttransistors 201 und des ersten Eingangstransistors 103 untereinander verbunden sind, während die Drain-Anschlüsse des zweiten Starttransistors 202 und des zweiten Eingangstransistors 104 und die Source-Anschlüsse des zweiten Starttransistors 202 und des zweiten Eingangstransistors 104 untereinander verbunden sind. Die beiden Gate-Anschlüsse der beiden Starttransistoren 201 und 202 sind untereinander verbunden und mit einer Referenzteilspannung 203 verbunden.

Die aus den beiden Starttransistoren 201 und 202 zusätzlich im Vergleich zu der in Fig. 1 gezeigten Schaltungsanordnung hinzugefügte Start-Schaltungseinheit dient einem Hochfahren (Starten) der Gesamtschaltungsanordnung in einen gewünschten Arbeitspunkt, da die gesamte Schaltungsanordnung neben dem gewünschten noch weitere unerwünschte stabile Arbeitspunkte aufweist. Liegen die ersten und zweiten Eingangssignale 101 und 102 auf einem zu tiefen Potential, dann sperren der erste Eingangstransistor 103 und der zweite Eingangstransistor 104. Dadurch nehmen die ersten und zweiten Referenzschaltungsknoten 129 und 130 ein hohes Potential an, während die ersten und zweiten Ausgangsschaltungsknoten ein niedriges Potential annehmen.

Die Gleichtaktregelung versucht nun, die ersten und zweiten Referenzschaltungsknoten 129 und 130 auf ein niedrigeres Potential zu ziehen. Da die Gleichtaktregelung nur mit einem Teilstrom arbeitet, kann sie die ersten und zweiten Referenzschaltungsknoten 129 und 130 nicht auf ein niedrigeres Potential ziehen.

Durch die Parallelschaltung des ersten Starttransistors 201 parallel zu dem ersten Eingangstransistor 103 und die Parallelschaltung des zweiten Starttransistors 202 parallel zu dem zweiten Eingangstransistor 104 wird erreicht, daß die ersten und zweiten Referenzschaltungsknoten 129 und 130 auf ein niedrigeres Potential gezogen werden, indem an die beiden verbundenen Gate-Anschlüsse der ersten und zweiten Starttransistoren 201 und 202 eine Referenzteilspannung 203 angelegt wird, die um einen bestimmten Betrag kleiner als die Referenzspannung 122 ist.

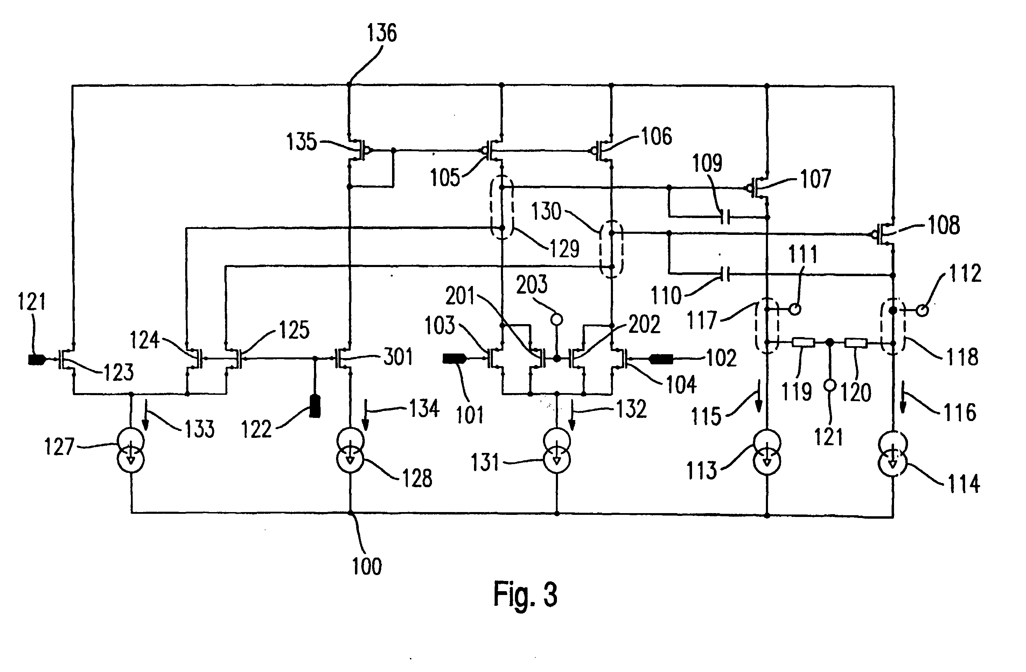

Fig. 3 veranschaulicht ein Ausführungsbeispiel einer Schaltungsanordnung gemäß der vorliegenden Erfindung, wobei die in Fig. 3 gezeigte Schaltungsanordnung im wesentlichen der in Fig. 2 gezeigten Schaltungsanordnung entspricht, außer dass der Drain-Anschluss (bzw. ebenfalls der Gate-Anschluss) des Lasttransistors 135 mit dem Drain-Anschluss eines Anpasstransistors 301 verbunden ist. Der Source-Anschluss des Anpasstransistors 301 ist mit dem ersten Anschluß der Laststromquelle 128 verbunden, während der Gate-Anschluss des Anpasstransistors 301 mit der Referenzspannung 122 verbunden ist. Auf diese Weise wird der Laststrom 134 von der Laststromquelle 128 an den Eingangsstrom (132) der Eingangsstromquelle (131) sowie den Referenzstrom (133) der Referenzstromquelle (127) angepaßt.

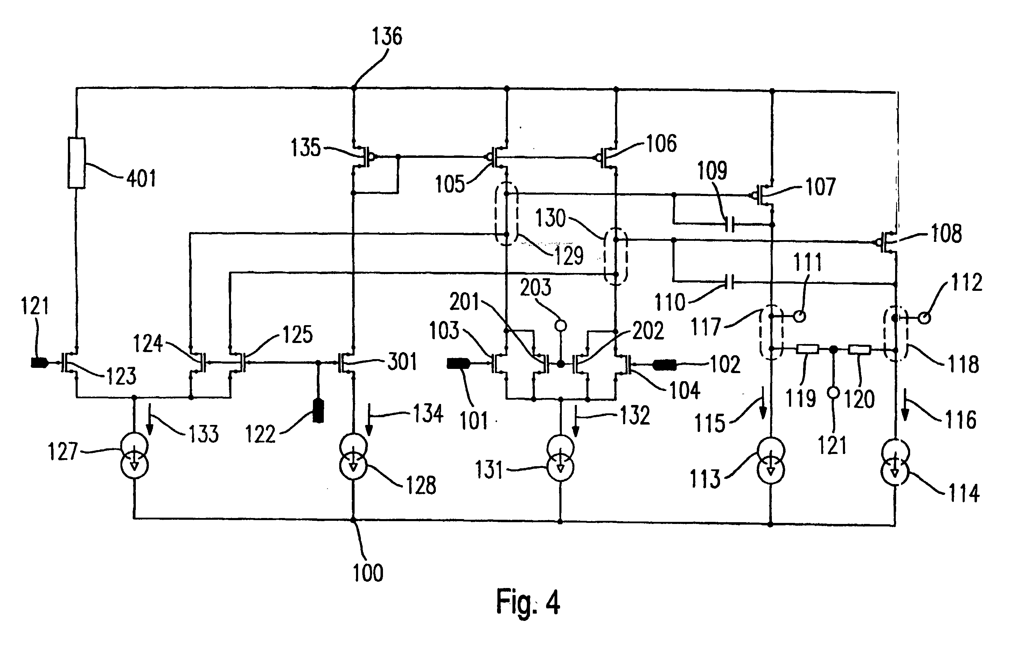

Fig. 4 veranschaulicht ein Ausführungsbeispiel einer Schaltungsanordnung gemäß der vorliegenden Erfindung, wobei die in Fig. 4 gezeigte Schaltungsanordnung im wesentlichen der in Fig. 3 gezeigten Schaltungsanordnung entspricht, außer daß zwischen dem Drain-Anschluss des ersten Referenztransistors 123 und dem Versorgungsschaltungsknoten 136 eine erste Referenzlast 401 geschaltet ist, die aus einem Widerstand oder aus einer Diodenlast ausgebildet ist.

Obwohl die vorliegende Erfindung vorstehend anhand bevorzugter Ausführungsbeispiele beschrieben wurde, ist sie darauf nicht beschränkt, sondern auf vielfältige Weise modifizierbar. Die Erfindung ist ausschließend durch die Ansprüche definiert.

### Bezugszeichenliste

In den Figuren bezeichnen gleiche Bezugszeichen gleiche oder funktionsgleiche Komponenten.
- 100: Masseschaltungsknoten
- 101: Erstes Eingangssignal
- 102: Zweites Eingangssignal
- 103: Erster Eingangstransistor
- 104: Zweiter Eingangstransistor
- 105: Erster Stromspiegeltransistor
- 106: Zweiter Stromspiegeltransistor
- 107: Erster Ausgangstransistor
- 108: Zweiter Ausgangstransistor
- 109: Erste Kompensationskapazität
- 110: Zweite Kompensationskapazität
- 111: Erstes Ausgangssignal
- 112: Zweites Ausgangssignal
- 113: Erste Ausgangsstromquelle
- 114: Zweite Ausgangsstromquelle
- 115: Erster Ausgangsstrom
- 116: Zweiter Ausgangsstrom
- 117: Erster Ausgangsschaltungsknoten
- 118: Zweiter Ausgangsschaltungsknoten
- 119: Erster Rückführwiderstand
- 120: Zweiter Rückführwiderstand
- 121: Rückführsignal
- 122: Referenzspannung
- 123: Erster Referenztransistor
- 124: Zweiter Referenztransistor
- 125: Dritter Referenztransistor
- 127: Referenzstromquelle
- 128: Laststromquelle
- 129: Erster Referenzschaltungsknoten
- 130: Zweiter Referenzschaltungsknoten
- 131: Eingangsstromquelle
- 132: Eingangsstrom
- 133: Referenzstrom
- 134: Laststrom
- 135: Lasttransistor
- 136: Versorgungsschaltungsknoten
- 201: Erster Starttransistor
- 202: Zweiter Starttransistor
- 203: Referenzteilspannung
- 301: Anpaßtransistor
- 401: Erste Referenzlast
- 501: Erste Referenzlast
- 502: Zweite Referenzlast
- 503: Erster Referenzdifferenztransistor
- 504: Zweiter Referenzdifferenztransistor

## Patentansprüche

1. Schaltungsanordnung zur Verstärkung von Eingangssignalen mit:
einer aus einem ersten Eingangstransistor (103) und einem zweiten Eingangstransistor (104) bestehenden Differenzeingangsstufe zur Eingabe eines differenziellen Eingangssignals (101, 102), deren Ausgänge einen ersten und zweiten Referenzknoten (129, 130) bilden;
einer aus einem ersten Ausgangstransistor (107) und einem zweiten Ausgangstransistor (108) bestehenden Differenzausgangsstufe zur Ausgabe eines differenziellen Ausgangssignals (111, 112);
einer Eingangsstromquelle (131) zur Einstellung eines Eingangsstroms (132) und einer Referenzstromquelle (127) zur Einstellung eines Referenzstroms (133); und
einer Referenzstufe zum Vergleichen einer Gleichtaktspannung der Differenzverstärker-Schaltungsanordnung mit einer Referenzspannung (122);
**dadurch gekennzeichnet, dass**
eine Laststromquelle (128) zur Einstellung eines Laststroms (134) vorgesehen ist;
eine einen ersten Stromspiegeltransistor (105) und einen zweiten Stromspiegeltransistor (106) umfassende Stromspiegeleinrichtung zur Spiegelung des Laststroms (134) in die Differenzeingangsstufe vorgesehen ist, deren Ausgänge mit dem ersten und zweiten Referenzknoten (129, 130) verbunden sind; und
die Referenzstufe einen ersten, zweiten und dritten Referenztransistor (121, 124, 125) umfasst, von denen die Ausgänge des zweiten und dritten Referenztransistors (124, 125) mit dem ersten und zweiten Referenzknoten (129, 130) verbunden sind.

2. Schaltungsanordnung nach Anspruch 1,
**dadurch gekennzeichnet,**
**dass** eine aus einem ersten Starttransistor (201) und einem zweiten Starttransistor (202) bestehende Start-Schaltungseinheit zum Starten der Gesamtschaltungsanordnung bereitgestellt ist, die jeweils parallel zu den ersten und zweiten Eingangstransistoren (103, 104) geschaltet sind.

3. Schaltungsanordnung nach einem der Ansprüche 1 oder 2,
**dadurch gekennzeichnet,**
**dass** eine Gleichtaktregelung bereitgestellt ist, bei welcher der Referenzstrom (133) nur ein Teil des durch eine Laststromquelle (128) bereitgestellten Laststroms (134) ist.

4. Schaltungsanordnung nach einem der Ansprüche 1 bis 3,
**dadurch gekennzeichnet,**
**dass** der zweite und dritte Referenztransistor (124, 125) eine Steilheit kleiner als jene des ersten und zweiten Eingangstransistors (103, 104) aufweisen.

5. Schaltungsanordnung nach einem der Ansprüche 1 bis 4,
**dadurch gekennzeichnet,**
**dass** ein Anpasstransistor (301) bereitgestellt ist, dessen Gate-Anschluss mit einer Referenzspannung (122) beaufschlagt ist, und dessen Drain-Source-Strecke den Laststrom (134) durchleitet.

6. Schaltungsanordnung nach einem der Ansprüche 1 bis 5,
**dadurch gekennzeichnet,**
**dass** eine vor dem Eingang der Stromspiegeleinrichtung als ein als eine Diodenlast geschalteter Lasttransistor (135) ausgebildet ist.

## Claims

1. Circuit arrangement for amplifying input signals having:
a differential input stage comprising a first input transistor (103) and a second input transistor (104) and serving for the inputting of a differential input signal (101, 102), the outputs of which differential input stage form a first and second reference node (129, 130);
a differential output stage comprising a first output transistor (107) and a second output transistor (108) and serving for the outputting of a differential output signal (111, 112);
an input current source (131) for setting an input current (132) and a reference current source (127) for setting a reference current (133); and
a reference stage for comparing a common-mode voltage of the differential amplifier circuit arrangement with a reference voltage (122);
**characterized in that**
provision is made of a load current source (128) for setting a load current (134);
provision is made of a current mirror device comprising a first current mirror transistor (105) and a second current mirror transistor (106) and serving for mirroring the load current (134) into the differential input stage, the outputs of which are connected to the first and second reference nodes (129, 130); and
the reference stage comprises a first, second and third reference transistor (121, 124, 125), of which the outputs of the second and third reference transistors (124, 125) are connected to the first and second reference nodes (129, 130).

2. Circuit arrangement according to Claim 1,
**characterized**
**in that** provision is made of a start circuit unit comprising a first start transistor (201) and a second start transistor (202) and serving for starting the overall circuit arrangement, which are respectively connected in parallel with the first and second input transistors (103, 104).

3. Circuit arrangement according to either of Claims 1 and 2,
**characterized**
**in that** a common-mode control is provided in which the reference current (133) is only a part of the load current (134) provided by a load current source (128).

4. Circuit arrangement according to one of Claims 1 to 3,
**characterized**
**in that** the second and third reference transistors (124, 125) have a transconductance less than that of the first and second input transistors (103, 104).

5. Circuit arrangement according to one of Claims 1 to 4,
**characterized**
**in that** a matching transistor (301) is provided, to whose gate terminal a reference voltage (122) is applied and whose drain-source path transmits the load current (134).

6. Circuit arrangement according to one of Claims 1 to 5,
**characterized**
**in that** a upstream of the input of the current mirror device is formed as a load transistor (135) connected as a diode load.

## Revendications

1. Montage de circuits servant à amplifier des signaux d'entrée, lequel comporte :
un étage d'entrée différentiel, constitué d'un premier transistor d'entrée (103) et d'un deuxième transistor d'entrée (104) et servant à introduire un signal d'entrée différentiel (101, 102), dont les sorties forment un premier et un deuxième noeud de circuit de référence (129, 130) ;
un étage de sortie différentiel constitué d'un premier transistor de sortie (107) et d'un deuxième transistor de sortie (108) et servant'à délivrer un signal de sortie différentiel (111, 112) ;
une source de courant d'entrée (131) servant à régler un courant d'entrée (132) et une source de courant de référence (127) servant à régler un courant de référence (133) ; et
un étage de référence servant à comparer une tension de mode commun du montage de circuits formant amplificateur différentiel à une tension de référence (122) ;
**caractérisé en ce que**
il est prévu une source de courant de travail (128) servant à régler un courant de travail (134) ;
il est prévu un dispositif formant miroir de courant, comprenant un premier transistor de miroir de courant (105) et un deuxième transistor de miroir de courant (106) et servant à refléter le courant de travail (134) dans l'étage d'entrée différentiel, dont les sorties sont reliées aux premier et deuxième noeuds de référence (129, 130) ; et **en ce que**
l'étage de référence comprend un premier, un deuxième et un troisième transistor de référence (121, 124, 125), les sorties des deuxième et troisième transistors de référence (124, 125) étant reliées aux premier et deuxième noeuds de référence (129, 130).

2. Montage de circuits selon la revendication 1,
**caractérisé en ce qu'**une unité formant circuit de démarrage, constituée d'un premier transistor de démarrage (201) et d'un deuxième transistor de démarrage (202) respectivement montés en parallèle aux premier et deuxième transistors d'entrée (103, 104), est disponible pour assurer le démarrage de l'ensemble du montage de circuits.

3. Montage de circuits selon l'une des revendications 1 ou 2,
**caractérisé en ce qu'**il est prévu une commande en mode commun dans laquelle le courant de référence (133) n'est qu'une partie du courant de travail (134) fourni par une source de courant de travail (128).

4. Montage de circuits selon une ou plusieurs des revendications 1 à 3,
**caractérisé en ce que** les deuxième et troisième transistors de référence (124, 125) présentent une pente inférieure à celle des premier et deuxième transistors d'entrée (103, 104).

5. Montage de circuits selon une ou plusieurs des revendications 1 à 4,
**caractérisé en ce qu'**il est prévu un transistor d'adaptation (301) à la borne de grille duquel une tension de référence (122) est appliquée et dont la section drain-source laisse passer le courant de travail (134).

6. Montage de circuits selon l'une des revendications 1 à 5,
**caractérisé en ce qu'**une charge placée avant l'entrée du dispositif formant miroir de courant est réalisée sous forme de transistor de charge (135) monté comme une charge de diode.
